# EUROPÄISCHE PATENTSCHRIFT

(11) **EP 3 123 531 B1**
(45) Veröffentlichungstag und Bekanntmachung des Hinweises auf die Patenterteilung: **05.01.2022**
(21) Anmeldenummer: 15707321.4
(22) Anmeldetag: 25.02.2015
(51) Int. Cl.: H01L 33/50, H01L 33/58

(54) **LED MODUL MIT INTEGRIERTER SEKUNDÄROPTIK**
LED MODULE HAVING AN INTEGRATED SECONDARY OPTICAL UNIT
MODULE LED COMPRENANT UN DISPOSITIF OPTIQUE SECONDAIRE INTÉGRÉ

(30) Priorität: 27.03.2014 DE 102014205729; 09.09.2014 DE 102014217986
(43) Veröffentlichungstag der Anmeldung: 01.02.2017
(73) Patentinhaber: Tridonic GmbH & Co. KG, 6850 Dornbirn (AT)
(72) Erfinder: PFEILER-DEUTSCHMANN, Martin, A-8330 Feldbach (AT); WIMMER, Florian, A-2650 Payerbach (AT); SCHRANK, Franz, 8074 Raada (AT)
(74) Vertreter: Rupp, Christian
(86) Internationale Anmeldenummer: PCT/EP2015/053870
(87) Internationale Veröffentlichungsnummer: WO 2015/144375

(56) Entgegenhaltungen:
- EP-A1- 1 418 628
- EP-A2- 1 657 758
- DE-A1-102008 025 756
- DE-U1-202004 011 015
- GB-A- 2 464 102
- JP-A- 2004 193 581
- JP-A- 2005 039 104
- US-A- 4 143 394
- US-A1- 2009 115 313

## Beschreibung

Die vorliegende Erfindung betrifft ein LED Modul, insbesondere ein LED Module für Außenanwendungen, bei denen ein Berührungs- und Feuchteschutz oder eine Sekundäroptik über einen mit Farbkonversionsmittel überzogenen LED-Chip integral aufgebracht ist.

Für die bisher bekannten LED Module ist es Stand der Technik, dass ein Sekundärelement beispielsweise ein Berührungs- oder Feuchteschutz auf einem LED Chip aufgebracht wird, nachdem dieser auf einer Leiterplatte positioniert und mit Vergussmasse wie beispielsweise einer Masse aus Epoxidharz vergossen wurde.

Die EP 2 264 796 lehrt beispielsweise die Aufbringung eines LED Chips auf einer Leiterplatte oder einem Substrat mit anschließendem Auftrag einer Vergussmasse, in welche Farbkonversionsmaterial eingebracht ist. Anschließend wird eine Kegeloptik als Sekundäroptik über dem LED Chip und der Vergussmasse mit Farbkonversionsmaterial positioniert.

Diese Anordnungsweise weist den Nachteil auf, dass die Abstrahlcharakteristik des LED-Chips bzw. der farbkonvertierten LED Lichtquelle durch die aufgebrachte Sekundäroptik verändert werden kann. Insbesondere kann sich hierdurch eine Abweichung vom einem ursprünglich eingestellten und geprüften Farbwert oder Farbkoordinaten des von der LED Lichtquelle emittierten Lichts einstellen. Des Weiteren kann die spätere Aufbringung der Sekundäroptik zu Gaseinschlüssen zwischen den Grenzflächen der Sekundäroptik und dem Farbkonversionsmittel der LED Lichtquelle führen, was das spätere Eindringen von Feuchtigkeit in die Lichtquelle begünstigen kann. Weitere LED-Module werden in den Dokumenten GB 2 464 102 A, US 2009/115313 A1 und EP 1 657 758 A2 offenbart.

Der vorliegenden Erfindung liegt daher die Aufgabe zugrunde eine verbesserte Anordnung und einen verbesserten Anordnungsprozess für ein Sekundärelement wie beispielsweise eine Sekundäroptik auf einem LED-Chip bereitzustellen, welche die oben dargelegten Nachteile ausräumt.

Diese Aufgabe wird durch die unabhängigen Ansprüche der vorliegenden Anmeldung gelöst.

Ein erster Aspekt der Erfindung betrifft ein LED-Modul aufweisend ein Trägersubstrat, wenigstens einen LED Chip, welcher auf dem Trägersubstrat angeordnet ist, eine den LED Chip wenigstens teilweise kontaktierende Farbkonversionsschicht, welche wenigstens einen Teil des vom LED Chip emittierten Primärlichts in ein Licht anderer Wellenlänge konvertiert, und eine Sekundäroptik, welche in Abstrahlrichtung hinter der Farbkonversionsschicht angeordnet ist, wobei die Sekundäroptik integral mit der Farbkonversionsschicht ausgebildet ist.

Durch die Farbkonversionsschicht, welche einerseits den wenigstens einen LED-Chip kontaktiert und andererseits integral mit der Sekundäroptik ausgebildet ist, wird ein kompaktes farbkonvertiertes LED-Modul bereitgestellt.

Die Farbkonversionsschicht ist vorzugsweise direkt auf einer Lichteintrittsfläche der Sekundäroptik angeordnet und mit dieser verbunden. Die integrale Ausbildung der Sekundäroptik mit der Farbkonversionsschicht bedeutet, dass die Farbkonversionsschicht vorzugsweise ohne Einschlüsse von Gas oder flüssigen Medien direkt, d.h. ohne Zwischenschicht oder Klebemitteln, mit der Sekundäroptik verbunden ist.

Die Verbindung zwischen der Sekundäroptik, der Farbkonversionsschicht und dem LED Chip findet vorzugweise in einem noch nicht ausgehärteten Zustand der Farbkonversionsschicht statt. Hierdurch wird eine integrale Ausgestaltung insbesondere der Sekundäroptik und der Farbkonversionsschicht erzielt, welche den LED-Chip kontaktiert.

Die Farbkonversionsschicht ist vorzugsweise derart angeordnet, dass sie den LED-Chip wenigstens teilweise, vorzugsweise vollständig, umgibt. Die Farbkonversionsschicht kontaktiert dabei vorzugsweise wenigstens die komplette Oberfläche des LED-Chips, welche im fertigen LED-Modul gegenüberliegend zur Lichteintrittsfläche der Sekundäroptik angeordnet ist. Die Farbkonversionsschicht kontaktiert vorzugsweise auch das den wenigstens einen LED-Chip tragende Trägersubstrat. Es wird demnach ein integrales Bauteil bereitgestellt, in welchem wenigstens der LED-Chip, die Farbkonversionsschicht und die Sekundäroptik eine integrale, fest verbundene Einheit bilden.

Im Gegensatz zum Stand der Technik, in welchem eine Sekundäroptik auf den vorgefertigten und ausgehärteten farbkonvertierten LED-Chip angeordnet wird, lässt sich gemäß der vorliegenden Erfindung das Sekundärelement nicht mehr als zusammenhängendes Bauteil von der farbkonvertierten LED, d.h. der LED-Farbstoff-Einheit, trennen, so dass weiterhin ein farbkonvertiertes Element erhalten bleibt.

Die Konzentration der Leuchtstoffpartikel in der Farbkonversionsschicht kann konstant oder variabel sein. In einem bevorzugten Ausführungsbeispiel variiert die Konzentration der Leuchtstoffpartikel in der Farbkonversionsschicht in Lichtaustrittsrichtung durch die Schicht. Vorzugsweise nimmt die Leuchtstoffkonzentration in Lichtaustrittsrichtung zu, d.h. nahe am LED-Chip ist eine relativ geringere Leuchtstoffkonzentration vorhanden, die mit zunehmender Entfernung vom LED-Chip in Lichtaustrittsrichtung steigt.

Alternativ oder zusätzlich kann die Konzentration des Leuchtstoffs in einer Breitenerstreckung, welche sich vorzugsweise parallel zu der Lichteintrittsfläche der Sekundäroptik erstreckt, konstant sein oder variieren. Hierbei kann die Konzentration insbesondere im Bereich einer Lichtaustrittsfläche des LED-Chips im Vergleich zur restlichen Farbkonversionsschicht erhöht sein. Des Weiteren kann die Konzentration des Leuchtstoffs in der Breitenerstreckung gezielt moduliert sein, etwa durch einen gezielten Dispensvorgang, um beispielsweise die Leuchtstoffkonzentration optimal auf Optikeffekte der Sekundäroptik abzustimmen.

Der wenigstens eine LED-Chip ist vorzugsweise eine monochromatischer LED-Chip und emittiert vorzugsweise blaues Licht einer Wellenlänge zwischen 420 und 480 nm.

Die Farbkonversionsschicht weist wenigstens eine Art von Leuchtstoffpartikeln auf. Die Partikel sind vorzugsweise anorganische Leuchtstoffpartikel, wie beispielsweise gelb und/oder grün emittierende Granate z.B. YAG:Ce³⁺, LuAG Ce³⁺, (YGd)AG: Ce³⁺ Phosphorpartikel oder Phosphorpartikel eines mit Europium dotierte Erdalkali-Orthosilikats (z.B. (Ba, Sr)₂SiO₄: Eu²⁺), welche in einer Matrix der Farbkonversionsschicht dispergiert sind. Die Matrix ist vorzugsweise eine Silikon Matrix, in welche die Phosphorpartikel dispergiert sind.

Die Farbkonversionsschicht kann wenigstens zwei Lagen von Leuchtstoffpartikel - aufweisen. Hierbei sind die Lagen vorzugsweise zeitlich hintereinander auf die Sekundäroptik aufgebracht und damit vorzugsweise hintereinander in Lichtaustrittsrichtung angeordnet. Die unterschiedlichen Lagen der Leuchtstoffpartikel können gleichartige oder unterschiedliche Leuchtstoffpartikel aufweisen

Die Farbkonversionsschicht kann Streupartikel enthalten.

Die Farbkonversionsschicht kann vorzugsweise Silikon- und/oder Epoxidharz enthalten, welches eine Trägermatrix für die Leuchtstoffpartikel und/oder Streupartikel bereitstellt. Optional kann die Matrix aus PMMA oder anderen bekannten Polymere hergestellt werden.

Die Gasdurchlässigkeit des angewendeten Materials als Matrix der Leuchtstoffpartikel und/oder der Streupartikel liegt vorzugsweise bei 0.1 bis 30 cm³/(m² day atm), mehr bevorzugt bei 0.1 bis 5 cm³/(m² day atm).

Die Sekundäroptik des LED Moduls ist vorzugsweise aus Glas oder Kunststoff und ist transparent. Die Sekundäroptik stellt damit vorzugsweise einen Berührungsschutz und/oder Feuchteschutz für den abgedeckten LED-Chip bereit.

Durch die Sekundäroptik findet vorzugsweise keine Wellenlängenveränderungen des von dem wenigstens einen LED-Chip emittierten Lichts statt. Des Weiteren weist die Sekundäroptik vorzugsweise keine Streueffekte auf.

Die Sekundäroptik kann an ihrer Lichteintrittsfläche eine Vertiefung oder einen Rücksprung aufweisen, in welchem die Farbkonversionsschicht integral geformt is-t. Die Vertiefung oder der Rücksprung bildet hierbei vorzugsweise eine wannenartige Vertiefung, welche zur Aufnahme der Farbkonversionsschicht ausgebildet ist. Vorzugsweise ist die Vertiefung derart geformt, dass diese wenigstens einen LED-Chip einschließen kann. Ein Boden der wannenartigen Vertiefung, welcher die Lichteintrittsfläche darstellt ist vorzugsweise plan. Der Boden kann indessen auch profiliert sein, vorzugsweise um gezielt optische Effekte und/oder eine Kompensation für Sekundäroptikeffekte zu erzielen.

Die Sekundäroptik kann auch aus einem planen bzw. ebenen Element bestehen, welches integral mit der Farbkonversionsschicht ausgebildet ist. Hierbei weist das LED-Modul vorgzugsweise einen sogenannten "Dam-and-fill"-Aufbau auf, bei welchem auf dem Trägersubstrat ein Damm angeordnet ist, welcher den wenigstens einen LED-Chip umgibt. Die Höhe des Damms ist vorgzugsweise derart gewählt, dass diese größer ist als die Höhe des wenigstens einen LED-Chips, ausgehend von der Oberfläche des Trägersubstrats. Der Damm wird vorzugsweise durch ein Dispensverfahren direkt auf das Trägersubstrat aufgebracht. Die durch den Damm entstehende Kavität, in welcher der wenigstens eine LED Chip angeordnet ist, ist mit Vergussmasse gefüllt, welche Farbkonversionspartikel enthält. Diese Vergussmasse stellt somit die Farbkonversionsschicht dar. Auch der Damm selbst kann Farbkonversionspartikel enthalten.

Die Sekundäroptik in Form eines planen bzw. ebenen Elements ist erfindungsgemäß integral mit der Farbkonversionsschicht ausgebildet. Dies kann dadurch erfolgen, dass das plane bzw. ebene Element in einem noch nicht ausgehärteten Zustand der Farbkonversionsschicht und/oder des diese umgebenen Damms mit der Farbkonversionschicht und/oder dem Damm kontaktiert wird. Die Sekundäroptik kann beispielsweise auf die Farbkonversionsschicht und/oder den Damm aufgelegt und durch leichten Anpressdruck mit wenigstens einem Teil der Oberfläche der Farbkonversionsschicht und/oder des Damms verbunden werden. Der weitere (Aus)Härtungsprozess der Farbkonversionsschicht und/oder des Damms führt dann zu einer kraftschlüssigen Verbindung der jeweiligen Bauteile.

In einer alternativen Ausgestaltungsform, die nicht Teil der Erfindung ist, wird die Sekundäroptik nach dem Aushärtungsprozess der Farbkonversionsschicht und/oder des Damms auf der Farbkonversionsschicht und/oder dem Damm aufgebracht. Hierbei kann die Sekundäroptik mit der Oberfläche der Farbkonversionsschicht und/oder des Damms verklebt sein.

In einem bevorzugten Ausführungsbeispiel ist die Sekundäroptik mit der Lichtemissionsfläche der Farbkonversionsschicht verbunden. Zusätzlich kann die Sekundäroptik auch mit wenigstens einem Teil der Damm-Oberfläche verbunden sein. Vorgzusweise ist der Rest des Trägersubstrats bzw. des LED Moduls, inbesondere ein den Damm umgebener Bereich des Trägersubstrats nicht von der Sekundäroptik abgedeckt.

Die erfindungsgemäße Ausgestaltungsform hat gegenüber den bekannten "dam-and-fill"-LED Modulen bzw. LED Spotlight Lichtquellen, welche keine derartige Sekundäroptik aufweisen, eine Reihe von Vorteilen. Inbesondere werden mechanische, technische und chemische Schwachstellen der bekannten "dam-and-fill"-LED Module gelöst.

So ist die aus thermomechanischen Gründen weich zu wählende Vergussmasse gegenüber Berührungen, beispielsweise bei der Montage des LED-Moduls, erfolgreich geschützt. Es kann daher ausgeschlossen werden, dass die unter der Vergussmasse liegende Elektronik bei der Montage oder während des Transports durch Berührung beschädigt wird. Insbesondere bei der Montage müssen daher auch keine spezifischen Vorkehrungen mehr getroffen werden, welche ein ungewolltes Berühren der Vergussmasse ausschließen.

Des Weiteren kann die Oberfläche des LED Moduls bzw. der LED Spotlight Lichtquelle im Gegensatz zu den "Dam-and-fill"-LED Modulen des Standes der Technik leicht gereinigt werden. Die Oberfläche, welche somit keine schmutzziehende Oberfläche mehr besitzt, welche durch den Einsatz von Silikon als Vergussmasse entsteht, wird daher von dauerhafter Verschmutzung verschont. Hierdurch kann ein möglicher Verlust von Lichtstrom durch die Verschmutzung der Oberfläche sowie Überhitzung der Oberfläche verhindert werden.

Des Weiteren werden die oben genannten Vorteile erzielt, ohne dass die Lichtfarbe und der Lichtstrom des LED Moduls oder der LED Spotlight Lichtquelle beeinträchtigt oder verändert wird, wie dies beispielsweise bei nachträglich aufgebrachten Linsensystemen der Fall ist.

Durch die integral mit der Farbkonversionsschicht verbundene Sekundäroptik wird des Weiteren ein integrierter mechanischer Überlastungsindikator bereitgestellt. Insbesondere führt eine mechanische Überbelastung des LED Modules bei Fertigung oder Transport zu wenigstens einem teilweisen Bruch der Sekundäroptik, wodurch die Auslieferung bzw. Bereitstellung von fehlerhaften LED Modulen durch Sichtkontrolle erfolgreich vermieden werden kann.

Das plane bzw. ebene Element der Sekundäroptik ist vorzugsweise eine Glas- oder Kunststoffscheibe bzw. ein Glas- oder Kunststoffplättchen.

Die Sekundäroptik weist vorzugsweise eine homogene Dicke auf. Die Dicke der Sekundäroptik liegt vorzugsweise zwischen 0,05 mm und 0,5 mm, mehr bevorzugt zwischen 0,15 mm und 0,3 mm.

Die Lichtdurchlässigkeit der Sekundäroptik bzw. des Materials der Sekundäroptik liegt vorzugsweise bei 95 bis 100%, mehr bevorzugt bei 98 bis 100%.

In einem bevorzugten Ausführungsbeispiel weist die Sekundäroptik im Wellenlängenbereich des sichtbaren Lichts eine Transparenz von mindestens 90%, bevorzugt zwischen 95 und 100% auf.

Das Material der Sekundäroptik kann auch in flüssigem Zustand bereitgestellt und ausgehärtet werden. Hierbei kann ein Dispensverfahren verwendet werden. In einem weiteren bevorzugten Ausführungsbeispiel kann das Material der Sekundäroptik in einem Co-Dispensverfahren zusammen mit der Farbkonversionsschicht auf den LED-Chip oder in ein formgebendes Werkzeug auf- bzw. eingebracht und ausgehärtet werden.

In einem weiteren bevorzugten Ausführungsbeispiel kann das Sekundärelement über den reinen Berührungsschutz und/oder Feuchteschutz weitere optische Eigenschaften wie beispielsweise Bündelung oder andere Linseneffekte aufweisen. Die Sekundäroptik kann auch einen integrierten Reflektor aufweisen.

Die Sekundäroptik kann einseitig oder beidseitig mit einer optisch wirksamen Beschichtung, beispielsweise einer Antireflex und/oder einer optional spektral verändernden Beschichtung versehen sein.

In einem weiteren Aspekt betrifft die Erfindung ein Verfahren zur Herstellung eines LED-Moduls aufweisend die Schritte:
- Auftragen einer flüssigen Farbkonversionsschicht auf eine Lichteintrittsfläche einer Sekundäroptik, derart, dass ein Sedimentieren der in der Farbkonversionsschicht vorliegenden Farbkonversionspartikel in Richtung der Lichteintrittsfläche stattfindet,
- Aufbringen wenigstens eines LED Chips auf die Oberfläche eines Trägersubstrats,
- Einbringen eines LED Chips in die Farbkonversionsschicht in einem wenigstens teilweise flüssigen Zustand der Farbkonversionsschicht,
- Aushärten der Farbkonversionsschicht.

Gemäß dieser Ausführungsform der Erfindung wird die flüssige Farbkonversionsschicht bzw. eine Matrix, welche die Leuchtstoffpartikel enthält, nicht auf den wenigstens einen LED-Chip und auf das den LED-Chip haltende Trägersubstrat vergossen, sondern vielmehr auf einer Lichteintrittsfläche der Sekundäroptik aufgebracht, die dem LED-Chip zugewandt ist, bevor dann diese Baugruppe aus Sekundäroptik, Farbkonversionsschicht und LED-Chip nach dem wenigstens teilweise Einbringen des LED-Chips in die Farbkonversionsschicht durch Aushärten verklebt wird.

Das Auftragen der flüssigen Farbkonversionsschicht findet vorzugsweise durch einen steuerbaren Dispensvorgang statt. Vorzugsweise wird/werden insbesondere die lichtemittierende(n) Fläche(n) des wenigstens einen LED-Chips komplett in die Farbkonversionsschicht eingebracht bzw. eingedrückt.

Die Farbkonversionsschicht wird vorzugsweise in einen Rücksprung oder eine Vertiefung der Sekundäroptik aufgebracht. Diese ist vorzugsweise derart geformt, dass er den wenigstens einen LED-Chip vollständig aufnehmen kann.

Durch das Aufbringen der Farbkonversionsschicht auf die Lichteintrittsfläche der Sekundäroptik kann ein Sedimentstieren der in der Farbkonversionsschicht vorliegenden Farbkonversions- bzw. Phosphorpartikel in Richtung der Lichteintrittsfläche stattfinden. Dies führt zu einer Bereitstellung einer erhöhten Phosphorpartikel-Konzentration in unmittelbarer Nähe der Lichteintrittsfläche der Sekundäroptik, wobei die Konzentration in einer Richtung weg von der Oberfläche (und hin zu dem LED-Chip) abnimmt.

Dass der Gradient der Leuchtstoffpartikel-Konzentration in einer Richtung weg von dem LED-Chip ansteigt ist in starkem Gegensatz zu den bekannten Auftragsverfahren, bei dem es durch eine direkten Dispensauftrag auf den LED-Chip eher zu dem Effekt kommt, dass ein Sedimentieren hin zu der Oberseite des LED-Chips erfolgt.

Ein weiteres Verfahren, das nicht Teil der Erfindung ist, weist die folgenden Schritte auf:
- Aufbringen wenigstens eines LED Chips auf die Oberfläche eines Trägersubstrats,
- Auftragen eines wenigstens teilweise flüssigen Damms auf die Oberfläche des Trägersubstrats derart, das dieser den wenigstens einen LED Chip umgibt,
- Einbringen einer wenigstens teilweise flüssigen Farbkonversionsschicht in eine durch den Damm auf der Obefläche des Trägersubstrats geformte Kavität,
- Aufbringen einer Sekundäroptik auf die Oberfläche der Farbkonversionssicht und/oder des Damms in einem wenigstens teilweise flüssigen Zustand der Farbkonversionsschicht und/oder des Damms, und
- Aushärten der Farbkonversionsschicht und des Damms.

Gemäß dieser Ausführungsform wird zunächst ein Damm auf die Oberfläche des Trägersubstrats aufgetragen, welcher den wenigstens einen LED Chip umfänglich umgibt. Vorgzusweise wird der Damm in teilflüssigem bzw. viskosem Zustand mit Hilfe eines Dispensverfahrens aufgetragen. Der Damm ist vorzugsweise aus Silikonmaterial geformt. Der Damm ist vorzugsweise in einem vorbestimmten Abstand um den LED Chip auf der Trägersubstratoberfläche angeordnet. Die Viskosität des Dammmaterials ist vorzugsweise derart angepasst, dass der Damm in der auf die Trägersubstratoberfläche aufgetragenen Position verweilt und nicht unkontrolliert über die Trägersubstratoberfläche fließt. Nach der Auftragung des Damms wird die wenigstens teilweise flüssige Farbkonversionsschicht bzw. eine Matrix, welche die Leuchtstoffpartikel enthält, in die durch den Damm auf dem Trägersubstrat geformte Kavität vergossen. Durch das Vergießen der Kavität mit der Farbkonversionsschicht, erfolgt eine Kontaktierung der Farbkonversionsschicht mit der Trägersubstratoberfläche, mit dem wenigstens einen LED Chip und den inneren Seitenwänden des Damms. Der Damm weist vorgzusweise eine derartige Höhe auf, dass ein vollständiges Vergießen bzw. Füllen der geformten Kavität mit der Farbkonversionsschicht zu einem vollständigen Einschließen des wenigstens einen LED Chips in der Kavität führt.

In einem nachfolgenden Schritt wird die Sekundäroptik auf die Oberfläche der Farbkonversionsschicht in einem wenigstens teilweise flüssigen Zustand dieser Schicht aufgebracht. Die Sekundäroptik wird dabei vorzugsweise derart positioniert, dass diese in Draufsicht über dem wenigstens einen LED Chip angeordnet bzw. dass deren Konturen in Draufsicht den wenigstens einen LED Chip umschließen. Die Abmaße der Sekundäroptik sind demzufolge größer als die des wenigstens einen LED Chips in Draufsicht.

Die Sekundäroptik kann derart geformt sein, dass deren Abmaße im Wesentlichen der Größe der durch den Damm geformten Kavität und/oder den Konturen des Damms in Draufsicht entsprechen. Inbesondere können die Abmaße der Sekundäroptik, wie beispielsweise deren Außendurchmesser, kleiner oder gleich den Außenkonturen, wie beispielsweise dem Außendurchmesser, des Damms in Draufsicht sein.

Durch das Aufbringen auf die wenigstens teilweise flüssige Farbkonversionsschicht und/oder den diese umgebenen Damm wird die Lichteintrittsfläche der Sekundäroptik fest mit der Oberfläche bzw. Lichtaustrittsfläche der Farbkonversionsschicht und/oder der Oberfläche des Damms verbunden. Dies kann durch ein leichtes Anpressen bzw. Eindrücken der Sekundäroptik auf die Oberfläche der Farbkonversionsschicht und/oder des Damms unterstützt werden.

Durch die nachfolgende, gemeinsame Aushärtung der Farbkonversionsschicht und/oder des Damms mit der aufgebrachten Sekundäroptik, kann eine integrale Ausgestaltung des LED Moduls erzielt werden, bei welcher insbesondere eine kraftschlüssige Verbindung zwischen den einzelnen Bauteilen vorliegt.

Das Auftragen des Damms und der Farbkonversionsschicht findet vorzugsweise durch einen steuerbaren Dispensvorgang statt.

Vorzugsweise werden die lichtemittierende(n) Fläche(n) des wenigstens einen LED-Chips komplett in der Farbkonversionsschicht vergossen.

Die Sekundäroptik besteht vorzugsweise aus einem planen bzw. ebenen Element, wie beispielsweise einer Glas- oder Kunststoffscheibe bzw. einem Glas- oder Kunststoffplättchen. Diese kann eine Dicke zwischen 0,05 mm und 0,5 mm, mehr bevorzugt zwischen 0,15 mm und 0,3 mm aufweisen.

In einer bevorzugten Ausführungsform werden die optischen Eigenschaften, vorzugsweise die Farbcharakteristik, des von dem LED-Chip durch die Sekundäroptik emittierten Lichts vor dem Aushärten der Farbkonversionsschicht gemessen. Hierdurch ist eine Beurteilung der optischen Eigenschaften noch vor dem Aushärten und damit vor dem Verkleben von Sekundäroptik, der Farbkonversionsschicht des LED-Chips und gegebenenfalls des Damms möglich. Dies ermöglicht die Beurteilung der optischen Eigenschaften des LED-Moduls unter Berücksichtigung möglicher optischer Einflüsse durch die Farbkonversionsschicht und die Sekundäroptik. Es ist somit bereits im Fertigungsprozess eine Vermessung und Beurteilung der optischen Eigenschaften des finalen LED-Moduls möglich.

Die Messung der optischen Eigenschaften werden vorzugsweise mit Hilfe eines Funktionstest durchgeführt bei dem die optischen Eigenschaften bei betriebenem LED-Chip bzw. bei betriebener LED-Strecke und darüber angeordneter Farbkonversionsschicht und Sekundäroptik getestet werden. Zum Zeitpunkt der Messung ist vorzugsweise noch keine fest Verbindung zwischen dem LED-Chip, der Farbkonversionsschicht, der Sekundäroptik und gegebenenfalls des Damms vorhanden, so dass beispielsweise durch weiteres Aufbringen von Farbkonversionsmaterial auf die Lichteintrittsfläche der Sekundäroptik bzw. in die Kavität des Damms die optischen Eigenschaften des LED-Chips kalibriert werden können, bevor eine feste Verbindung mit dem die LED-Chip und gegebenenfalls dem den LED-Chip tragenden Element wie beispielsweise ein Trägersubstrat bzw. den einzelnen Komponenten des LED Moduls stattfindet.

Zur Messung der optischen Eigenschaften des LED-Moduls ist vorzugsweise eine spezielle Messvorrichtung vorgesehen. Diese kann einen Sensor zur Messung der Helligkeit und/oder Farbcharakteristik des LED-Moduls aufweisen. Die Messvorrichtung kann mit einer Vorrichtung zur Adaption der Menge und/oder Konzentration der Farbkonversionsschicht verbunden sein.

In einem bevorzugten Ausführungsbeispiel wird vorzugsweise die Menge und/oder Konzentration der auf die Lichteintrittsfläche der Sekundäroptik aufgebrachten bzw. in die Kavität des Damms eingebrachte Farbkonversionsschicht in Abhängigkeit der gemessenen optischen Eigenschaften angepasst.

Bevorzugt kann hierbei zusätzliches Leuchtstoffmaterial in die Farbkonversionsschicht eingebracht werden, bis die gemessenen optischen Eigenschaften des LED-Moduls mit zuvor definierten Werten übereinstimmen. Dabei können beispielsweise wenigstens zwei Lagen von Farbkonversionsmaterial auf die Lichteintrittsfläche der Sekundäroptik aufgebracht bzw. in die Kavität des Damms eingebracht werden.

In einem weiteren bevorzugten Ausführungsbeispiel werden wenigstens zwei Lagen Farbkonversionsschicht auf die Lichteintrittsfläche der Sekundäroptik aufgebracht bzw. in die Kavität des Damms eingebracht, welche vorzugsweise unterschiedliche Leuchtstoffpartikel enthalten. Dabei kann eine Messung bzw. Kalibrierung nach dem Aufbringen jeder der unterschiedlichen Lagen Farbkonversionsschicht oder aber erst nach dem Aufbringen aller Schichten durchgeführt werden

Als Beispiel für ein mehrlagiges Farbkonversionssystem, das also auf die Lichteintrittsfläche wie beispielsweise eine wannenartige Vertiefung des Sekundärelements aufgebracht wird, ist wie folgt:
Zuerst werden beispielsweise gelb emittierende Farbkonversionspartikel in einer Matrix auf die Lichteintrittsfläche der Sekundäroptik aufgebracht, und daraufhin in einer weiteren Lage rot emittierende Farbkonversionspartikel in einer Matrix. Somit wird es dann bei dem Zusammenbringen des Sekundärelements mit dem LED-Chip bzw. mit dem den LED-Chip tragenden Trägersubstrat zu einer Anordnung kommen, bei der mit Effizienzvorteil die rote Phosphorlage in unmittelbarem Kontakt zu den LEDs steht, während die gelbe emittierende Phosphorlage eben durch diese rot emittierende Phosphorlage von dem wenigstens einen LED-Chip getrennt ist.

Die oben beschriebene Anordnung der einzelnen Farbkonversionsschichten bzw. Farbkonversionslagen kann in umgekehrter Weise auch bei einem in "dam-and-fill"-Weise hergestelltem LED Module angewendet werden. Hierbei wird in die Kavität des Damms zunächst eine erste Lage mit vorzugsweise rot emittierenden Farbkonversionspartikeln eingebracht bzw. auf den LED Chip in der Kavität aufgebracht. Auf diese wird dann anschließend eine weitere Lage mit vorzugsweise gelb emittierenden Farbkonversionspartikeln aufgebracht.

In einem weiteren Aspekt betrifft die Erfindung ein LED-Modul aufweisend wenigstens einen farbkonvertierten LED-Chip und eine darauf aufgebrachte Sekundäroptik, herstellbar nach einem der Verfahren wie oben beschrieben.

Die vorliegende Erfindung wird nun noch detaillierter mit Bezug auf die beigefügten Zeichnungen beschrieben.
Fig. 1 zeigt eine seitliche Schnittansicht eines bevorzugten Ausführungsbeispiels eines LED-Moduls gemäß der vorliegenden Erfindung.
Fig. 2 zeigt eine seitliche Schnittansicht eines weiteren bevorzugten Ausführungsbeispiels eines LED-Moduls gemäß der vorliegenden Erfindung.
Fig. 3a bis 3c zeigen schematisch die einzelnen Schritte eines bevorzugten Ausführungsbeispiels eines erfindungsgemäßen Verfahrens.
Fig. 4a und 4b zeigen weitere Ausführungsbeispiele des erfindungsgemäßen LED-Moduls.

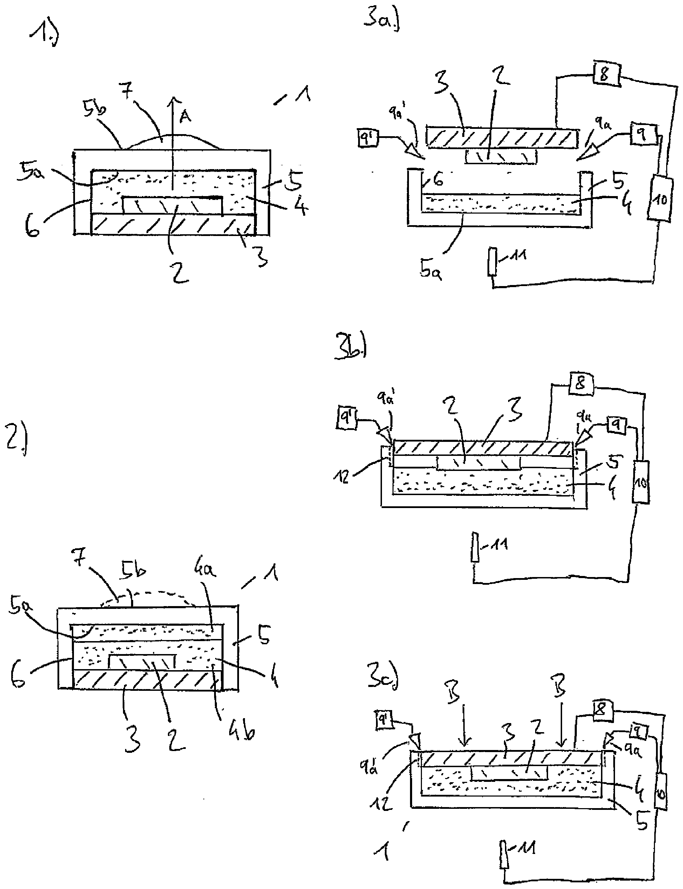

In Figur 1 ist ein erstes bevorzugtes Ausführungsbeispiel für ein erfindungsgemäßes LED-Modul dargestellt. Das LED Modul 1 weist wenigstens einen bevorzugt monochromatischen LED Chip 2 auf, welcher mit seiner Unterseite auf einem Trägersubstrat 3 aufgebracht ist. Der LED Chip 2 kann mit Hilfe von Bonddrähten mit Leiterbahnen des Trägersubstrats 3 verbunden sein. Alternativ kann der LED Chip 2 auch in face-down Anordnung mit vorgesehenen Kontakten des Trägersubstrats verbunden sein.

Der LED Chip 2 ist an seinen dem Trägersubstrat 3 abgewandten Oberflächen vorzugsweise vollständig mit einer Farbkonversionsschicht 4 umgeben, welche Leuchtstoffpartikel zur teilweisen Farbkonversion des vom LED Chip 2 emittierten Lichts aufweist. Die Farbkonversionsschicht 4 kann vorzugsweise Streupartikel enthalten (nicht dargestellt).

Die Farbkonversionsschicht 4 kann vorzugsweise als Matrix ein Silikon- und/oder Epoxidharz enthalten. Optional kann die Matrix der Schicht 4 aus PMMA oder andere bekannte Polymere hergestellt werden. Die Gasdurchlässigkeit des angewendeten Materials als Matrix der Farbkonversionsschicht 4 liegt vorzugsweise bei 0.1 bis 30 cm³/(m² day atm), mehr bevorzugt bei 0.1 bis 5 cm³/(m² day atm).

Oberhalb des LED Chips 2 ist eine Sekundäroptik 5 angeordnet, welche vorzugsweise aus einem transparenten Material wie beispielsweise Plastik oder Glas geformt ist. Das Material der Sekundäroptik kann auch in flüssigem Zustand bereitgestellt und ausgehärtet werden. Hierbei kann ein Dispensverfahren verwendet werden.

In einem weiteren bevorzugten Ausführungsbeispiel kann das Material der Sekundäroptik in einem Co-Dispensverfahren zusammen mit der Farbkonversionsschicht 4 auf den LED-Chip oder in ein formgebendes Werkzeug auf- bzw. eingebracht und ausgehärtet werden.

Die Lichtdurchlässigkeit des Materials der Sekundäroptik liegt vorzugsweise bei 95 bis 100%, mehr bevorzugt bei 98 bis 100%. Die Sekundäroptik dient zusätzlich als Berührungs- und Feuchteschutz des LED Moduls 1. Die Sekundäroptik kann ein integriertes Optikmodul wie beispielsweise eine integrierte Linse 7 aufweisen. Die Linse 7 ist vorzugsweise zur Bündelung des von dem LED Chip 2 emittierten Lichts ausgeprägt. Alternativ kann auch ein Optikelement zur Streuung des vom LED Chip 2 emittierten Lichts vorgesehen sein.

Die Sekundäroptik 5 weist eine wannenförmige Vertiefung bzw. einen Rücksprung 6 auf, welcher die Farbkonversionsschicht 4 und den LED Chip 2 umgibt. Eine innere Lichteintrittsfläche 5a der Sekundäroptik ist dabei vorzugsweise plan ausgebildet. Die Lichteintrittsfläche 5a bzw. der Boden der Vertiefung 6 kann alternativ auch profiliert oder konkav ausgebildet sein.

Die Farbkonversionsschicht 4 ist vorzugsweise direkt mit der Sekundäroptik 5 verbunden. Dies bedeutet, dass sich zwischen Sekundäroptik und der Farbkonversionsschicht 4 keine weiteren Zwischenschichten befinden, insbesondere keine gasförmigen Einschlüsse oder Klebeschichten. Hierdurch wird eine integrale Verbindung zwischen Farbkonversionsschicht 4 und Sekundäroptik 5 bereitgestellt.

Auch ist die Farbkonversionsschicht 4 direkt mit dem LED Chip 2 und vorzugsweise ebenfalls mit dem Trägersubstrat 3 des LED Chips 2 direkt verbunden. Auch zwischen Farbkonversionsschicht 4 und dem LED Chip 2 sowie dem Trägersubstrat 3 befinden sich somit vorzugsweise keine weiteren Schichten, insbesondere keine gasförmigen Einschlüsse oder Klebeschichten. Die hierdurch bereitgestellte integrale Ausgestaltung des LED Moduls 1 wird insbesondere durch das erfindungsgemäße Verfahren erhalten, welches weiter unten mit Referenz zu Figuren 3a bis 3c beschrieben wird.

Das vom LED Chip 2 emittierte Licht wird durch die den LED Chip umgebende Farbkonversionsschicht 4 wenigstens teilweise in Licht einer anderen Wellenlänge umgewandelt. Hierdurch entsteht ein Mischlicht, bevorzugt ein Weißlicht, welches von dem LED Modul 1 emittiert wird.

Das von dem LED Chip 2 und der Farbkonversionsschicht emittierte Mischlicht tritt durch die Lichteingangsfläche 5a der Sekundäroptik 5 ein und durch die Lichtausgangsfläche 5b der Sekundäroptik aus dem LED Modul 1 aus. Die Lichtausgangsfläche 5b kann beispielsweise eine strukturierte Oberfläche zur Homogenisierung der Farbe und/oder der Intensität des emittierten Lichtes aufweisen (z.B. gedrückte, aufgeklebte oder aufgeraute Strukturen).

Innerhalb der Farbkonversionsschicht 4 nimmt die Konzentration der Farbkonversionspartikel in Lichtaustrittsrichtung A vorzugsweise zu. Vorzugsweise ist die Farbkonversionspartikelkonzentration in einem Grenzbereich zwischen der Sekundäroptik 5 und der Farbkonversionsschicht 4 erhöht, relativ zu einem Bereich der Farbkonversionsschicht 4 nahe dem LED Chip 2.

Figur 2 zeigt ein weiteres bevorzugtes Ausführungsbeispiel, wobei die Farbkonversionsschicht 4 wenigstens zwei unterschiedliche Lagen 4a,4b von Farbkonversionspartikeln aufweist. Diese liegen in Lichtaustrittsrichtung A vorzugsweise hintereinander.

Die unterschiedlichen Lagen 4a,4b der Farbkonversionsschicht 4 weisen vorzugsweise unterschiedliche Farbkonversionspartikel auf. Die Farbkonversionspartikel der jeweiligen Lagen 4a,4b sind vorzugsweise jeweils in einer Trägermatrix dispergiert.

Die Lage 4b weist dabei vorzugsweise eine derartige Form und/oder Dicke auf, so dass der LED Chip 2 vollständig von dieser Lage umgeben ist. Die Lage 4b weist dabei vorzugsweise einen rot emittierenden Phosphor auf. Der rote Leuchtstoff kann beispielsweise ein rot emittierendes Q-dot aufweisen (z.B. Nanoteilchen von ZnS, CdS, ZnSe, CdSe, CdTe, oder ZnTe oder so-genannte Kern-Schale Teilchen der kombinierten Schale(n) und/oder Kern(e) der genannten Verbindungen). Die Anwendung der weiteren bekannten roten Leuchtstoffe wie z.B. Nitride (CaAlSiN₃:Eu²⁺, (CaSr)AlSiN₃:Eu²⁺, CaSiON₃:Eu²⁺) ist auch denkbar.

Die zweite Lage 4a der Farbkonversionsschicht 4 weist vorzugsweise einen gelb, grün oder gelb-grünlich emittierenden Phosphor auf.

Die einzelnen Lagen 4a, 4b der Farbkonversionsschicht sind ebenfalls direkt miteinander verbunden und somit ohne zusätzliche Schichten oder gasförmigen Einschlüsse ausgebildet.

Wie durch Referenznummer 7 dargestellt kann die Sekundäroptik optional eine Linse aufweisen.

Figuren 3a bis 3c zeigen ein bevorzugtes Ausführungsbeispiel eines erfindungsgemäßen Verfahrens zur Herstellung eines LED Moduls gemäß der vorliegenden Erfindung.

Figur 3a zeigt dabei die Anordnung der Sekundäroptik 5 mit dem zu füllenden Rücksprung 6 nach oben. Der LED Chip 2 ist vorzugsweise auf dem Trägersubstrat 3 angebracht und wird mit der LED Chip 2 nach unten oberhalb des Rücksprungs 6 positioniert. Hierfür können spezifische Haltemittel vorgesehen sein, welche die relative Positionierung von LED Chip 2, Trägersubstrat 3 und Sekundäroptik 5 ermöglichen.

Der LED Chip 2 und das Trägersubstrat 3 werden vorzugsweise derart bezüglich der Sekundäroptik 5 positioniert, dass eine Messvorrichtung 11, welche wenigstens einen Sensor umfasst, die von dem LED Chip 2 durch die Sekundäroptik 5 emittierte Strahlung bzw. das emittierte Licht messen kann. Hierfür wird der LED Chip 2 mit Hilfe einer Stromzufuhr 8 mit Strom für die Lichtemission des Chips 2 versorgt. Im Gegensatz zu bisher bekannten optischen Messverfahren findet demnach die Messung des emittierten Lichts des LED Moduls bereits unter Berücksichtigung etwaiger optischer Einflüsse der Sekundäroptik 5 auf das von dem LED Chip 2 emittierten Licht statt. Die optischen Eigenschaften des finalen LED Moduls 1 aufweisend eine Sekundäroptik 5 können daher bereits während des Produktionsprozesses des Moduls überprüft und konfiguriert werden. Es kann somit eine Verschiebung der optischen Eigenschaften des LED Chips 2, welche bei nachträglichem Aufbringen einer Sekundäroptik auftreten kann, verhindert werden.

Vorzugsweise findet eine erste Messung des von dem LED Chip 2 emittierten Lichts bereits vor Zugabe einer Farbkonversionsschicht in den Rücksprung 6 der Sekundäroptik 5 statt.

Für die Zugabe eines Farbkonversionsmittels bzw. der Farbkonversionsschicht 4 in den Rücksprung 6 ist eine Dispensvorrichtung 9,9' bereitgestellt, welche an eine Farbkonversionsmittelzufuhr angekoppelte Dispensdüsen 9a,9a' aufweist. Die Dispensdüsen 9a,9a' sind derart bezüglich der Sekundäroptik 5 und des LED Chips 2 auf dem Trägersubstrat 3 angeordnet, dass die Zufuhr von Farbkonversionsmittel zur Ausbildung einer Farbkonversionsschicht 4 im Rücksprung 6 der Sekundäroptik 5 ermöglicht wird. Insbesondere sind die Düsen 9a,9a' seitlich oberhalb des Rücksprungs 6 angeordnet. Für die Zugabe von Farbkonversionsmittel in den Rücksprung 6 kann die Sekundäroptik 5 Zufuhrkanäle 12 aufweisen (siehe Figur 3b,3c), welche eine vorzugsweise rückwärtig angeordnete, äußere Fläche der Sekundäroptik mit dem Rücksprung 6 verbinden.

Die Dispensvorrichtung 9,9', die optische Messvorrichtung 11 und vorzugsweise auch die LED Stromzufuhr 8 sind vorzugsweise mit einer Kontrollvorrichtung 10 verbunden. Die Kontrollvorrichtung ist vorzugsweise derart ausgeprägt, dass eine gezielte Anpassung der Menge und/oder Konzentration der Farbkonversionsschicht 4 im Rücksprung 6 der Sekundäroptik 5 in Abhängigkeit der von der Messvorrichtung 11 gemessenen optischen Parameter des LED Moduls 1 erfolgt.

Die Messung der optischen Parameter des LED-Moduls 1 kann zu diskreten Zeitpunkten oder kontinuierlich während des Dispensvorgangs der Farbkonversionsschicht 4 erfolgen. Die optischen Parameter können insbesondere die Helligkeit und/oder die Farbkoordinaten des von dem LED Modul 1 emittierten Lichts sein.

Wie in Figur 3a dargestellt wird vorzugsweise nach einem ersten Messvorgang eine erste Menge und/oder Konzentration von Farbkonversionsmaterial zur Ausbildung einer Farbkonversionsschicht 4 in den Rücksprung 6 durch die Dispensvorrichtung 9,9' geformt. Die Menge und/oder Konzentration der Farbkonversionsschicht 4 wird dabei vorzugsweise durch die Dispensvorrichtung 9,9' derart angepasst, dass die gemessenen optischen Parameter mit zuvor definierten Parametern oder mit einem Parameter-Bereich übereinstimmen. Dies kann in einzelnen Dispensschritten erfolgen, in denen nach und nach mehr Farbkonversionsmittel in die Farbkonversionsschicht 4 gegeben wird, wodurch die Dicke der Schicht 4 ansteigt, wie in Figur 3b dargestellt.

Sind die gewünschten optischen Parameter des LED Moduls 1 erreicht, wird das Trägersubstrat 3 zusammen mit dem LED Chip 2 in die Farbkonversionsschicht 4 eingebracht bzw. eingedrückt (siehe Pfeile B in Figur 3c). Das Eindrücken erfolgt derart, dass die Oberflächen das LED Chips 2 und die Oberfläche des Trägersubstrats 3 vollständig mit der Farbkonversionsschicht 4 in Berührung bzw. mit dieser kontaktiert sind. Die zur Zufuhr von Farbkonversionsmittel 4 angeordneten Zufuhrkanäle 12 der Sekundäroptik können beim Eindrücken des LED Chips 2 dazu dienen, dass an der Grenzfläche zwischen Farbkonversionsschicht 4 und Trägersubstrat 3 vorhandene Luft entweichen kann.

Um eine direkte Verbindung von Sekundäroptik 5, LED Chip 2 und Trägersubstrat 3 zu gewährleisten findet das Einbringen bzw. Eindrücken des LED Chips 2 in die Farbkonversionsschicht 4 bei wenigstens noch teilweise flüssiger Farbkonversionsschicht 4 statt. Anschließend wird durch Aushärten der Farbkonversionsschicht 4, beispielsweise durch eine Temperaturbehandlung, ein Verkleben des LED Moduls 1 erzielt.

In Übereinstimmung mit der in Figur 2 gezeigten Anordnung kann die Dispensvorrichtung 9,9' dazu ausgeprägt sein, unterschiedliche Farbkonversionsschichten 4a,4b in den Rücksprung 6 zu dispensen, wobei die einzelnen Schichten vorzugsweise unterschiedliche Leuchtstoffpartikel enthalten. Die Menge der unterschiedlichen Farbkonversionslagen 4a,4b kann dabei gezielt in Abhängigkeit der ermittelten optischen Parameter des LED Moduls 1 angepasst werden.

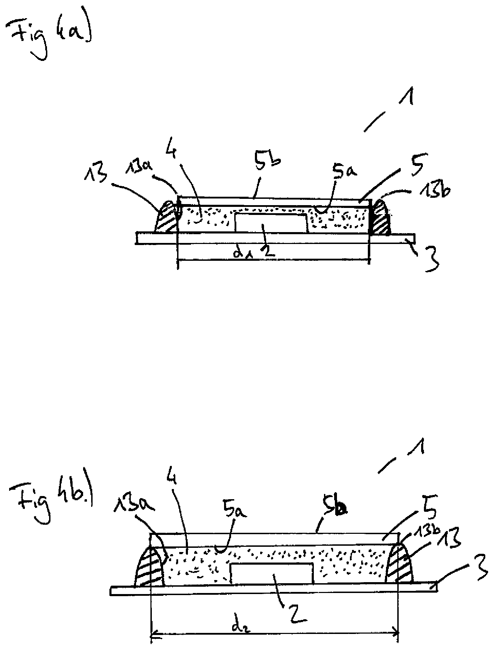

Fig. 4a und 4b zeigen weitere Ausführungsbeispiele des erfindungsgemäßen LED-Moduls. In diesen Ausführungsbeispielen ist die Sekundäroptik 5 ein im Wesentlichen planes bzw. ebenes Element, welches integral mit der Farbkonversionsschicht 4 und/oder einem, den wenigstens einen LED Chip 2 umgebenden Damm 13 ausgebildet. Das in Figuren 4a und 4b gezeigte LED Modul 1 weist einen sogenannten "dam-and-fill"-Aufbau auf, in welchem wenigstens ein LED Chip 2 auf das Trägersubstrat 3 aufgebracht wird. Ein den Chip umgebender Damm 13 wird anschließend, vorzugsweise mit Hilfe eines Dispensverfahrens, auf die den LED Chip 2 umgebende Trägeroberfläche in einem viskosen bzw. teilflüssigen Zustand aufgetragen. Die Viskosität des Dammmaterials ist vorzugsweise derart gewählt, dass ein unkontrolliertes Fließen des Dammmaterials auf der Oberfläche des Substrats 3 verhindert wird. Der Damm 13 hat vorzugsweise eine halbrunde Querschnittsfläche. Der Damm 13 kann in Draufsicht auf das LED Modul 1 beispielsweise kreisförmig, ellipsenförmig oder auch im Wesentlichen rechteckig um den wenigstens einen LED Chip 2 angeordnet sein. Der Damm 13 ist vorzugsweise aus Silikonmaterial geformt und kann optional Farbkonversionsmaterial enthalten.

Eine durch den Damm 13 geformte Kavität 13a ist mit Farbkonversionsmaterial bzw. einer Farbkonversionsschicht 4 ausgefüllt. Die besteht vorzugsweise aus einer Silikon- oder Epoxidmatrix, in welche Farbkonversionspartikel eingebracht sind. Die Farbkonversionsschicht 4 wird in einem wenigstens teilweise flüssigen Zustand in die Kavität 13a eingebracht.

Das plane Element der Sekundäroptik 5 ist transparent und besteht vorzugsweise aus Glas oder Kunststoff. Insbesondere kann die Sekundäroptik ein Glas- oder Kunststoffplättchen von relativ geringer Dicke sein. Die Sekundäroptik 5 weist eine vorzugsweise homogene Dicke auf. Die Dicke der Sekundäroptik liegt vorzugsweise zwischen 0,05 mm und 0,5 mm, mehr bevorzugt zwischen 0,15 mm und 0,3 mm.

Das plane Element 5 ist wenigstens mit der Farbkonversionsschicht 4 integral verbunden. Dies bedeutet, dass sich zwischen Sekundäroptik 5 und der Farbkonversionsschicht 4 keine weiteren Zwischenschichten befinden, insbesondere keine gasförmigen Einschlüsse oder Klebeschichten. Diese integrale Ausgestaltung erfolgt vorzugsweise durch Aufbringen des planen Elements 5 auf die Oberfläche der Farbkonversionsschicht 4 in wenigstens teilweise flüssigem Zustand. Durch das anschließende Aushärten der Farbkonversionsschicht 4 wird eine kraftschlüssige Verbindung zwischen den einzelnen Bauteilen erzielt. Vor und/oder während des Aushärtens des Moduls kann ein leichtes Eindrücken bzw. Einpressen des planen Elements 5 auf die Oberfläche der Farbkonversionsschicht 4 erfolgen.

Wie in Figur 4a gezeigt ist, kann das plane Element 5 derart angeordnet sein, dass dieses einen Großteil, vorzugsweise 75%, mehr bevorzugt wenigstens 85%-95% der Lichtaustrittsfläche der Farbkonversionsschicht 4 abdeckt. Hierbei weist die Außenkontur des planen Element 5 Abmessungen auf, welche im Wesentlichen den inneren Abmessungen der Kavität 13a entsprechen. Im gezeigten Ausführungsbeispiel weist die Sekundäroptik 5 einen Außendurchmesser d1 auf, welcher im Wesentlichen dem Innendurchmesser der Kavität 13a entspricht.

Figur 4b zeigt ein weiteres Ausführungsbeispiel, bei welchem die Sekundäroptik 5 über gegenüber dem Ausführungsbeispiel in Figur 4a relativ größere Außenabmessungen verfügt, so dass das Element 5 die Oberfläche der Farbkonversionsschicht 4 als auch wenigstens teilweise die Oberfläche des Damms 13 kontaktiert. Bei einer derartigen Anordnung sind die Außenabmessungen der Sekundäroptik 5 vorzugsweise derart gewählt, dass die Lichteintrittsfläche 5a des Elements 5 wenigstens einen obersten Scheitelpunkt 13b des Damms 13 kontaktiert. Durch den Aushärteprozess des Moduls wird somit eine integrale Ausgestaltung der Sekundäroptik 5 mit der Farbkonversionsschicht 4 und dem Damm 13 erzielt. Im gezeigten Ausführungsbeispiel weist die Sekundäroptik 5 einen Außendurchmesser d2 auf, welcher im Wesentlichen dem mittleren Durchmesser des Damms 13 entspricht, auf welchem der oberste Scheitelpunkt 13b angeordnet ist.

Vorzugsweise sind die Außenabmessungen des Sekundärelements 5 derart gewählt, dass die Außenkontur des planen Elements 5 in Draufsicht kleiner ist als die Außenkontur des Damms 13. In einem besonders bevorzugten Ausführungsbeispiel liegen die Außenabmessungen des Sekundärelements zwischen den in Figuren 4a und 4b gezeigten Durchmessern d1, d2.

Das mit Bezug auf die Figuren 3a bis 3c beschriebene Verfahren kann auch bei den Ausführungsbeispielen gemäß Figuren 4a und 4b angewandt werden. Hierbei wird die Farbkonversionsschicht 4 beziehungsweise die Farbkonversionsschichten 4a,4b nicht in einen Rücksprung 6 des Sekundärelements 5 aufgetragen, sondern in die durch den Damm 13 geformte Kavität 13a. Die Sekundäroptik 5 wird dabei in einem vordefinierten Abstand von der Kavität 13a gehalten, so dass bei Bedarf eine spezifische Menge an Farbkonversionsmaterial 4 in die Kavität 13a eingebracht werden kann. Dies erfolgt vorzugsweise seitlich zwischen der Sekundäroptik 5 und dem obersten Scheitelpunkt 13b des Damms 13, beispielsweise mit den in Figuren 3a bis 3c beschriebenen Dispensdüsen 9a,9a'.

## Patentansprüche

1. LED-Modul (1) aufweisend ein Trägersubstrat (3), wenigstens einen LED Chip (2), welcher auf dem Trägersubstrat (3) angeordnet ist,
eine den LED Chip wenigstens teilweise kontaktierende Farbkonversionsschicht (4), welche wenigstens einen Teil des vom LED Chip emittierten Primärlichts in ein Licht anderer Wellenlänge konvertiert, und
eine Sekundäroptik (5), welche in Abstrahlrichtung hinter der Farbkonversionsschicht (4) angeordnet ist, wobei die Sekundäroptik (5) integral mit der Farbkonversionsschicht (4) ausgebildet ist, wobei die Farbkonversionsschicht (4) direkt auf einer Lichteintrittsfläche (5a) der Sekundäroptik (5) derart aufgebracht ist, dass die in der Farbkonversionsschicht (4) vorliegenden Farbkonversionspartikel in Richtung der Lichteintrittsfläche (5a) sedimentiert sind,
wobei die integrale Ausgestaltung der Sekundäroptik (5) und der Farbkonversionsschicht (4) dadurch erhältlich ist, dass die Verbindung zwischen der Sekundäroptik (5), der Farbkonversionsschicht (4) und dem LED Chip in einem noch nicht ausgehärteten Zustand der Farbkonversionsschicht (4) stattfindet.

2. LED-Modul nach Anspruch 1, wobei die Farbkonversionsschicht (4) den LED Chip (2) wenigstens teilweise umgibt.

3. LED-Modul nach einem der vorhergehen Ansprüche, wobei innerhalb der Farbkonversionsschicht (4) die Konzentration der Leuchtstoffpartikel variiert, wobei vorzugsweise die Leuchtstoffkonzentration in Lichtaustrittsrichtung (A) zunimmt.

4. LED-Modul nach einem der vorhergehenden Ansprüche, wobei die Konzentration des Leuchtstoffs in einer Breitenerstreckung, welche sich vorzugsweise parallel zu der Lichteintrittsfläche (5a) der Sekundäroptik (5) erstreckt, konstant ist oder variiert.

5. LED-Modul nach einem der vorhergehenden Ansprüche, wobei die Farbkonversionsschicht (4) wenigstens zwei Lagen (4a,4b) von vorzugsweise unterschiedlichen Leuchtstoffpartikeln enthält.

6. LED-Modul nach einem der vorhergehenden Ansprüche, wobei die Sekundäroptik (5) transparent ist und eine Vertiefung oder einen Rücksprung (6) aufweist, in welchem die Farbkonversionsschicht (4) integral geformt ist.

7. LED-Modul nach einem der vorhergehenden Ansprüche 1 bis 3 oder 4 bis 5, wobei die Sekundäroptik (5) im Wesentlichen planar ausgeprägt ist und eine vorzugsweise homogene Dicke zwischen 0,05 mm und 0,5 mm, mehr bevorzugt zwischen 0,15 mm und 0,3 mm aufweist.

8. LED-Modul nach Anspruch 7,
wobei das LED-Modul einen die Farbkonversionsschicht (4) umgebenden Damm (13) aufweist, welcher integral mit der Farbkonversionsschicht (4) ausgebildet ist,
wobei vorzugsweise die Sekundäroptik (5) integral mit dem Damm (13) ausgebildet ist.

9. LED-Modul nach einem der vorhergehenden Ansprüche, wobei die Lichtdurchlässigkeit des Materials der Sekundäroptik (5) vorzugsweise bei 95 bis 100%, mehr bevorzugt bei 98 bis 100% liegt.

10. LED-Modul nach einem der vorhergehenden Ansprüche, wobei die Farbkonversionsschicht (4) eine Matrix aus Silikon- und/oder Epoxidharz, oder aus PMMA Polymer aufweist, wobei vorzugsweise die Gasdurchlässigkeit des angewendeten Materials als Matrix der Farbkonversionsschicht (4) vorzugsweise bei 0.1 bis 30 cm³/(m² day atm), mehr bevorzugt bei 0.1 bis 5 cm³/(m² day atm) liegt.

11. Verfahren zur Herstellung eines LED-Moduls aufweisend die Schritte:
- Auftragen einer flüssigen Farbkonversionsschicht (4) auf eine Lichteintrittsfläche (5a) einer Sekundäroptik (5), derart, dass ein Sedimentieren der in der Farbkonversionsschicht (4) vorliegenden Farbkonversionspartikel in Richtung der Lichteintrittsfläche (5a) stattfindet,
- Aufbringen wenigstens eines LED Chips (2) auf die Oberfläche eines Trägersubstrats (3),
- Einbringen des LED Chips (2) in die Farbkonversionsschicht (4) in einem wenigstens teilweise flüssigen Zustand der Farbkonversionsschicht,
- Aushärten der Farbkonversionsschicht (4).

12. Verfahren zur Herstellung eines LED-Moduls nach Anspruch 11, wobei eine lichtemittierende Fläche des LED Chips (2) komplett in die Farbkonversionsschicht (4) eingebracht wird.

13. Verfahren nach Anspruch 11 oder 12, wobei die optische Eigenschaften, vorzugsweise die Farbcharakteristik, des von dem LED-Chip durch die Sekundäroptik emittierten Lichts vor dem Aushärten der Farbkonversionsschicht (4) gemessen werden, wobei vorzugsweise die Menge und/oder Konzentration der aufgebrachten Farbkonversionsschicht (4) in Abhängigkeit der gemessenen Eigenschaften angepasst wird.

14. Verfahren nach Anspruch 13, wobei zusätzliches Leuchtstoffmaterial in die Farbkonversionsschicht (4) eingebracht wird, bis die gemessenen optischen Eigenschaften des LED-Moduls (1) mit vorbestimmten Werten übereinstimmen.

15. Verfahren nach einem der Ansprüche 11 bis 14, wobei wenigstens zwei Lagen Farbkonversionsschicht (4a,4b) aufgebracht werden, welche vorzugsweise unterschiedliche Leuchtstoffpartikel enthalten.

## Claims

1. LED module (1) comprising a carrier substrate (3), at least one LED chip (2) disposed on the carrier substrate (3),
a color conversion layer (4) which is at least partially in contact with the LED chip and which converts at least a portion of the primary light emitted by the LED chip into light of a different wavelength, and
a secondary optical unit (5) which is disposed in emission direction behind the color conversion layer (4), wherein the secondary optical unit (5) is configured integrally with the color conversion layer (4), wherein the color conversion layer (4) is directly applied to a light entry surface (5a) of the secondary optical unit (5) such that the color conversion particles present in the color conversion layer (4) are sedimented in the direction of the light entry surface (5a), wherein the integral design of the secondary optical unit and the color conversion layer (4) is obtainable in that the connection between the secondary optical unit (5), the color conversion layer (4) and the LED chip takes place in a not yet cured state of the color conversion layer (4).

2. LED module according to Claim 1, wherein the color conversion layer (4) at least partially surrounds the LED chip (2).

3. LED module according to any one of the preceding claims, wherein the concentration of the luminescent material particles varies within the color conversion layer (4), wherein the luminescent material concentration preferably increases in the light exit direction (A).

4. LED module according to any one of the preceding claims, wherein the concentration of luminescent material is constant or varies in a width extension which preferably extends parallel to the light entry surface (5a) of the secondary optical unit (5).

5. LED module according to any one of the preceding claims, wherein the color conversion layer (4) comprises at least two layers (4a,4b) of preferably different luminescent material particles.

6. LED module according to any one of the preceding claims, wherein the secondary optical unit (5) is transparent and comprises a depression or a recess (6) in which the color conversion layer (4) is integrally formed.

7. LED module according to any one of the preceding Claims 1 to 3 or 4 to 5, wherein the secondary optical unit (5) is substantially planar and has a preferably homogeneous thickness between 0.05 mm and 0.5 mm, more preferably between 0.15 mm and 0.3 mm.

8. LED module according to Claim 7,
wherein the LED module comprises a dam (13) which surrounds the color conversion layer and is configured integrally with the color conversion layer (4),
wherein the secondary optical unit (5) is preferably configured integrally with the dam (13).

9. LED module according to any one of the preceding claims, wherein the light permeability of the material of the secondary optical unit (5) is preferably 95 to 100%, more preferably 98 to 100%.

10. LED module according to any one of the preceding claims, wherein the color conversion layer (4) comprises a matrix of silicone resin and/or epoxy resin, or PMMA polymer, wherein the gas permeability of the material used as the matrix of the color conversion layer (4) is preferably 0.1 to 30 cm³/(m² day atm), more preferably 0.1 to 5 cm³/(m² day atm) .

11. Method for producing an LED module comprising the steps:
- applying a liquid color conversion layer (4) onto a light entry surface (5a) of a secondary optical unit (5) in such a way that sedimentation of the color conversion particles present in the color conversion layer (4) takes place in the direction of the light entry surface (5a),
- applying at least one LED chip (2) to the surface of a carrier substrate (3),
- incorporating the LED chip (2) into the color conversion layer (4) in an at least partially liquid state of the color conversion layer,
- curing the color conversion layer (4).

12. Method for producing an LED module according to Claim 11, wherein a light-emitting surface of the LED chip (2) is completely incorporated within the color conversion layer (4).

13. Method according to Claim 11 or 12, wherein the optical properties, preferably the color characteristics, of the light emitted by the LED chip through the secondary optical unit is measured before the color conversion layer (4) cures, wherein the amount and/or concentration of the applied color conversion layer (4) is preferably adjusted as a function of the measured properties.

14. Method according to Claim 13, wherein additional luminescent material is incorporated into the color conversion layer (4) until the measured optical properties of the LED module (1) match predetermined values.

15. Method according to any one of Claims 11 to 14, wherein at least two layers of color conversion layer (4a,4b) are applied, which preferably contain different luminescent material particles.

## Revendications

1. Module LED (1) présentant un substrat de support (3), au moins une puce LED (2) disposée sur le substrat de support (3),
une couche de conversion chromatique (4) en contact au moins partiel avec la puce LED et convertissant au moins une partie de la lumière primaire émise par la puce LED en une lumière d'une autre longueur d'onde, et
un dispositif optique secondaire (5) disposé en aval de la couche de conversion chromatique (4), vu dans la direction du rayonnement, le dispositif optique secondaire (5) étant formé d'un seul tenant avec la couche de conversion chromatique (4), ladite couche de conversion chromatique (4) étant appliquée directement sur une surface d'entrée de lumière (5a) du dispositif optique secondaire (5) de telle manière que les particules de conversion chromatique présentes dans la couche de conversion chromatique (4) se sédimentent en direction de la surface d'entrée de lumière (5a),
la conception d'un seul tenant du dispositif optique secondaire et de la couche de conversion chromatique (4) étant réalisable en raison du fait que la liaison entre le dispositif optique secondaire (5), la couche de conversion chromatique (4) et la puce LED s'effectue alors que la couche de conversion chromatique (4) se trouve dans un état non encore durci.

2. Module LED selon la revendication 1, dans lequel la couche de conversion chromatique (4) enveloppe au moins partiellement la puce LED (2).

3. Module LED selon l'une des revendications précédentes, dans lequel la concentration en particules luminophores est variable au sein de la couche de conversion chromatique (4), la concentration en luminophores augmentant de préférence dans le sens de sortie de lumière (A).

4. Module LED selon l'une des revendications précédentes, dans lequel la concentration en luminophores est constante ou variable dans le sens de la largeur, soit un sens de préférence parallèle à la surface d'entrée de lumière (5a) du dispositif optique secondaire (5).

5. Module LED selon l'une des revendications précédentes, dans lequel la couche de conversion chromatique (4) contient au moins deux couches (4a, 4b) de particules luminophores de préférence différentes.

6. Module LED selon l'une des revendications précédentes, dans lequel le dispositif optique secondaire (5) est transparent et présente une cavité ou un renfoncement (6) dans lequel la couche de conversion chromatique (4) est formée d'un seul tenant.

7. Module LED selon l'une des revendications précédentes 1 à 3, ou 4 et 5, dans lequel le dispositif optique secondaire (5) est estampé de façon à être plan et présente une épaisseur de préférence homogène comprise entre 0,05 mm et 0,5 mm, plus préférablement entre 0,15 mm et 0,3 mm.

8. Module LED selon la revendication 7,
présentant une barrière (13) entourant la couche de conversion chromatique (4) et formée d'un seul tenant avec la couche de conversion chromatique (4),
ledit dispositif optique secondaire (5) étant de préférence formé d'un seul tenant avec ladite barrière (13).

9. Module LED selon l'une des revendications précédentes, dans lequel le taux de transmission lumineuse du matériau du dispositif optique secondaire (5) est de préférence compris entre 95 et 100 %, plus préférablement entre 98 et 100 %.

10. Module LED selon l'une des revendications précédentes, dans lequel la couche de conversion chromatique (4) présente une matrice en silicone et/ou en résine époxyde, ou bien en polymère PMMA, la perméabilité aux gaz du matériau utilisé en tant que matrice de la couche de conversion chromatique (4) étant comprise de préférence entre 0,1 et 30 cm³/(m² jour atm), plus préférablement entre 0,1 et 5 cm³/(m² jour atm) .

11. Procédé de production d'un module LED présentant les étapes consistant à :
- appliquer une couche de conversion chromatique (4) liquide sur une surface d'entrée de lumière (5a) d'un dispositif optique secondaire (5) de telle manière que la sédimentation des particules luminophores présentes dans la couche de conversion chromatique (4) s'effectue en direction de la surface d'entrée de lumière (5a),
- disposer au moins une puce LED (2) sur la surface d'un substrat de support (3),
- introduire la puce à LED (2) dans la couche de conversion chromatique (4) alors que ladite couche de conversion chromatique se trouve dans un état au moins partiellement liquide,
- faire durcir la couche de conversion chromatique (4).

12. Procédé de production d'un module LED selon la revendication 11, dans lequel une surface émettrice de lumière de la puce LED (2) est complètement introduite dans la couche de conversion chromatique (4).

13. Procédé selon la revendication 11 ou 12, dans lequel les caractéristiques optiques, de préférence la caractéristique chromatique, de la lumière émise par la puce LED à travers le dispositif optique secondaire, sont mesurées avant le durcissement de la couche de conversion chromatique (4) ; la quantité et/ou la concentration de la couche de conversion chromatique (4) appliquée étant de préférence ajustées en fonction des propriétés mesurées.

14. Procédé selon la revendication 13, dans lequel il est réalisé un apport de matériau luminophore supplémentaire à la couche de conversion chromatique (4) jusqu'à ce que les propriétés optiques du module LED (1) correspondent à des valeurs prédéterminées.

15. Procédé selon l'une des revendications 11 à 14, dans lequel il est réalisé une application d'au moins deux couches de conversion chromatique (4a, 4b) contenant de préférence des particules luminophores différentes.
